# EUROPÄISCHE PATENTANMELDUNG

(11) **EP 1 403 652 A1**
(43) Veröffentlichungstag der Anmeldung: **31.03.2004**
(21) Anmeldenummer: 02021974.7
(22) Anmeldetag: 30.09.2002
(51) Int. Cl.: G01R 31/3185, G06F 11/26

(54) **Verfahren und Vorrichtung zur Prüfung der Abbildung/Implementierung eines Modells eines logischen Schaltkreises auf einen/in einem Hardware-Emulator**

(71) Anmelder: SIEMENS AKTIENGESELLSCHAFT, 80333 München (DE)
(72) Erfinder: Ghameshlu, Majid, 1110 Wien (AT); Krause, Karlheinz, 82152 Planegg (DE); Taucher, Herbert, 2340 Moedling (AT)
(74) Vertreter: Berg, Peter, Dipl.-Ing.

(57) **Zusammenfassung**

Es wird ein Verfahren zur Funktionsprüfung eines emulierten logischen Schaltkreises angegeben, bei dem ein Modell des logischen Schaltkreises in einen Hardware-Emulator (EM) geladen wird und dort in einen Betriebsmodus versetzt wird, in dem darin enthaltene Flip-Flops funktional zu einem oder mehreren Schieberegistern verkettet werden. Unter Zuhilfenahme dieses Betriebsmodus wird der strukturelle Aufbau des logischen Schaltkreises im Hardware-Emulator (EM) in Folge mit dem strukturellen Aufbau des Modells des logischen Schaltkreises verglichen. Weiterhin wird eine Vorrichtung zur Durchführung des Verfahrens offenbart.

## Beschreibung

Die Erfindung betrifft ein Verfahren zur Prüfung eines emulierten logischen Schaltkreises, bei dem ein Modell eines logischen Schaltkreises in einer Hardware-Beschreibungssprache in einen Hardware-Emulator geladen wird. Weiterhin betrifft die Erfindung eine Vorrichtung zur Durchführung des erfindungsgemäßen Verfahrens.

Die Komplexität moderner logischer Schaltkreise erfordert die Durchführung umfangreicher Funktionstests, die bereits frühzeitig in der Entwurfsphase erfolgen, um den Aufwand für eine eventuell erforderliche Korrektur möglichst gering zu halten. Aus diesem Grund existieren umfangreiche Möglichkeiten, einen in einem programmierbaren Rechner nachgebildeten, logischen Schaltkreis zu testen. Oft verfügt bereits die Entwurfs-Software über die nötigen Funktionen.

Trotz der hohen Rechenleistung der heute zur Verfügung stehenden Computer kann ein zumindest weitgehend vollständiger Funktionstest eines umfangreichen logischen Schaltkreises auf rein simulations-gestützter Basis mit vertretbarem Zeitaufwand jedoch nicht durchgeführt werden. Ein Beispiel für einen solchen Schaltkreis ist ein sogenannter "Application specific integrated circuit", kurz ASIC.

Aus diesem Grund werden schon seit längerer Zeit Hardware-Emulatoren eingesetzt, die aus einer Vielzahl parametrierbarer logischer Gatter bestehen, die untereinander beliebig verknüpft werden können. Dabei wird das am Computer erstellte Modell des logischen Schaltkreises für den Funktionstest in den Hardware-Emulator geladen, welcher durch entsprechende Parametrierung den zu prüfenden logischen Schaltkreis simuliert. Durch entsprechende Beschaltung der Ein- und Ausgänge des Emulators, was üblicherweise mit Hilfe eines programmierbaren Rechners erfolgt, kann der Test in vergleichsweise kurzer Zeit durchgeführt werden, da die einzelnen Schaltvorgänge in einem Hardware-Emulator deutlich schneller ablaufen, als dies mit einer Software-Simulation der Fall wäre. Das Modell des logischen Schaltkreises liegt dabei beispielsweise als sogenanntes "Register Transfer Level Modell" oder als Netzliste vor.

Durch die Verwendung von Hardware-Emulatoren ergeben sich jedoch weitere Probleme. Einerseits muss das in einem programmierbaren Rechner gespeicherte Modell eines logischen Schaltkreises auf eine Netzliste auf dem Hardware-Emulator abgebildet werden. Dieser Vorgang erfolgt aufgrund der Komplexität rechnergestützt und ist für den Menschen nur schwer nachvollziehbar, weswegen dabei auftretende Fehler praktisch nicht erkannt werden können.

Eine weitere Fehlerquelle sind ausgefallene Module im Hardware-Emulator, die noch nicht als solche erkannt wurden. Selbst wenn die Abbildung des Modells des logischen Schaltkreises auf die Netzliste fehlerfrei erfolgt, führt ein defektes Modul, das einen Teil des logischen Schaltkreises emulieren soll, in der Regel zu einem Fehlverhalten des emulierten logischen Schaltkreises.

Unglücklicherweise ist die Unterscheidung, ob ein Fehlverhalten des logischen Schaltkreises auf einen Entwurfsfehler, einen Fehler bei der Abbildung auf die Netzliste oder einen Defekt im Hardware-Emulator zurückzuführen ist, vorderhand nicht erkennbar, da Möglichkeiten für den Selbsttest eines Hardware-Emulators nicht oder in nur geringem Umfang existieren. Eine Fehleranalyse ist dementsprechend aufwändig und wiederum fehleranfällig.

Der Erfindung liegt also die Aufgabe zugrunde, ein Verfahren zur Prüfung der Abbildung/Implementierung eines Modells eines logischen Schaltkreises auf einen/in einem Hardware-Emulator anzugeben, welches die angeführten Nachteile nicht aufweist.

Dies geschieht erfindungsgemäß mit einem Verfahren der eingangs genannten Art,
- bei dem der emulierte logische Schaltkreis in einen Betriebsmodus versetzt wird, in dem einige oder alle der darin enthaltenen Flip-Flops, insbesondere unter Zwischenschaltung weitere logischer Einheiten, funktional zu einem oder mehreren Schieberegistern verkettet werden und
- bei dem der strukturelle Aufbau des logischen Schaltkreises im Hardware-Emulator unter zumindest teilweiser Zuhilfenahme dieses Betriebsmodus mit dem strukturellen Aufbau des Modells des logischen Schaltkreises verglichen wird.

Durch die Verkettung der einzelnen Flip-Flops zu einem oder mehreren Schieberegistern ist die Funktionsweise des zu prüfenden logischen Schaltkreises besonders einfach und daher leicht nachvollziehbar. Unter Zuhilfenahme dieses Betriebsmodus des logischen Schaltkreises, welcher auch unter dem Begriff "Scan-Modus" bekannt ist, kann mit vergleichsweise wenig technischem Aufwand eine Aussage darüber getroffen werden, ob der strukturelle Aufbau des logischen Schaltkreises im Hardware-Emulator mit dem strukturellen Aufbau des modellierten logischen Schaltkreises vergleichbar beziehungsweise überhaupt ident ist.

Nur bei Gleichheit kann von einer korrekten Abbildung des Modells des logischen Schaltkreises auf den Hardware-Emulator und der korrekten Funktion des Hardware-Emulators ausgegangen werden. Erst unter dieser Voraussetzung kann ein sinnvoller Test des Entwurfs des logischen Schaltkreises beginnen, da andernfalls in der Regel nicht klar ist, ob ein unvorhergesehenes Verhalten des Schaltkreises auf einen Fehler im Entwurf oder auf einen Fehler der Abbildung auf den Hardware-Emulator zurückzuführen ist.

Dabei ist der für das erfindungsgemäße Verfahren nötige Scan-Modus vielfach ohnehin Bestandteil des Modells des logischen Schaltkreises, weswegen eine Umsetzung der Erfindung dort besonders einfach möglich ist.

Ergänzend wird angemerkt, dass der hier erwähnte Scan-Modus eine andere Zielsetzung verfolgt, als der von der Joint Test Action Group, kurz JTAG, festgelegte Standard IEEE 1149.1, welcher sich im Wesentlichen auf die Funktionsprüfung im Zusammenhang mit gedruckten Schaltungen bezieht.

Zwar werden auch dort Flip-Flops zu Schieberegistern verkettet, jedoch dient dies nicht zum Test der Flip-Flops an sich beziehungsweise deren Verbindungen untereinander, sondern verfolgt den Zweck, Bauteile auf einer gedruckten Schaltung mit Hilfe einer genormten Schnittstelle testen zu können, wobei die zu testenden Bauteile nicht zwingend eine direkte Verbindung zu dieser Schnittstelle haben müssen, sondern in der Regel nur über andere Bauteile, die in einen speziellen Scan-Modus gesetzt werden, erreicht werden können.

Besonders vorteilhaft ist es auch,
- wenn an Eingänge des Emulators, welche gleichzeitig Eingänge von Schieberegistern darstellen, ein Testmuster angelegt wird und durch entsprechendes Takten in die Schieberegister geschoben wird,
- wenn der emulierte, logische Schaltkreis in einen normalen Betriebsmodus versetzt wird, eine oder mehrere Taktzyklen folgen und der Schaltkreis anschließend wieder in den ursprünglichen Betriebsmodus versetzt wird,
- wenn das daraus resultierende Ergebnismuster durch entsprechendes Takten an Ausgänge des Emulators, welche gleichzeitig Ausgänge der Schieberegister darstellen, geschoben wird und dort überprüft wird, ob es mit einem Erwartungswert übereinstimmt und
- wenn dieses Ergebnis für den Vergleich des strukturellen Aufbaus des logischen Schaltkreises im Hardware-Emulator mit dem strukturellen Aufbau des Modells des logischen Schalkreises herangezogen wird.

Bei dieser Variante der Erfindung wird an die Eingänge des Emulators, beziehungsweise der Schieberegister, ein Testmuster angelegt, welches vorzugsweise ebenso viele Bit breit ist, wie Eingänge vorhanden sind, und in das Schieberegister geschoben. Dieser Schiebevorgang kann prinzipiell beliebig oft erfolgen, jedoch ist das Befüllen aller Flip-Flops mit einem bekannten Wert durch das Schieben des Musters bis an die Endposition, das heißt bis an die Ausgänge der Schieberegister, vorteilhaft. Nach diesem Schiebevorgang wird der logische Schaltkreis in einen normalen Betriebsmodus versetzt, in welchem er jene Funktionen erfüllt, für die er eigentlich entworfen wurde. Danach folgt vorzugsweise ein Taktzyklus, beziehungsweise aber auch mehrere Taktzyklen, wodurch die Flip-Flops in einen Zustand entsprechend ihrer logischen Verknüpfung versetzt werden. Abschließend wird der logische Schaltkreis wieder in den "Scan-Modus" versetzt und das Ergebnismuster durch entsprechendes Takten an die Ausgänge des Hardware-Emulators geschoben. Dort wird es mit einem Erwartungswert verglichen, welcher etwa aus dem Modell des logischen Schaltkreises bekannt ist. Stimmt das Ergebnismuster nicht mit dem Erwartungswert überein, so kann davon ausgegangen werden, dass die Abbildung des logischen Schaltkreises auf den Hardware-Emulator nicht korrekt erfolgt ist oder der Hardware-Emulator defekt ist.

Vorteilhaft ist es auch,
- wenn an einen Eingang des Emulators, welcher gleichzeitig den Eingang eines Schieberegisters darstellt, ein Testmuster angelegt wird,
- wenn das Testmuster durch entsprechendes Takten durch das Schieberegister durchgeschoben wird,
- wenn ein Ausgang des Emulators, welcher gleichzeitig den Ausgang dieses Schieberegisters darstellt, auf das Erscheinen dieses oder des invertierten Testmusters hin überprüft wird,
- wenn aus der Anzahl der für das Durchschieben erforderlichen Taktsequenzen die Anzahl der im Schieberegister enthaltenen Flip-Flops ermittelt wird und
- wenn dieses Ergebnis für den Vergleich des strukturellen Aufbaus des logischen Schaltkreises im Hardware-Emulator mit dem strukturellen Aufbau des Modells des logischen Schaltkreises herangezogen wird.

Wegen der besseren Verständlichkeit wird ein einfacher Funktionsablauf vorgestellt, nämlich das Anlegen eines einzelnen Bits als Testmuster an einen Eingang, wobei zuvor vorzugsweise alle Flip-Flops mit dem Wert Null initialisiert werden. In Folge wird dieses Bit durch entsprechendes Takten so lange durch das Schieberegister weitergeschoben, bis dieses am Ausgang detektiert wird. Wird der Takt mit einer Zählvorrichtung gekoppelt, so kann die Anzahl der Flip-Flops direkt aus der Anzahl der für das Durchschieben erforderlichen Taktzyklen ermittelt werden. Stimmt die ermittelte Anzahl der Flip-Flops nicht mit der Anzahl überein, die etwa aus dem Modell des logischen Schaltkreises bekannt ist, so kann davon ausgegangen werden, dass die Abbildung des Modells des logischen Schaltkreises auf den Hardware-Emulator nicht korrekt erfolgt ist oder der Hardware-Emulator defekt ist.

Der erwähnte Fall bezieht sich auf eine Verkettung der Flip-Flops, welche keine oder eine gerade Anzahl von invertierenden logischen Elementen enthält. Andernfalls sind die angeführten logischen Werte umzukehren.

Selbstverständlich ist das erfindungsgemäße Verfahren auch mit einem anderem Testmuster durchzuführen. Gegebenenfalls kann durch entsprechende Prüfung auf das Erscheinen des Testmusters am Ausgang des Schieberregisters auf die Initialisierung der Flip-Flops verzichtet werden.

Eine vorteilhafte Variante der Erfindung ist auch mit einem Verfahren gegeben, wenn der Ausgang eines Schieberegisters mit dem Eingang eines nächsten Schieberegisters verbunden wird und durch Rekursion alle Schieberegister zu einem einzigen Schieberegister verkettet werden.

Die Funktionsprüfung gestaltet sich in diesem Fall besonders einfach, da für die Ermittlung der Anzahl der im Schieberegister enthaltenen Flip-Flops - vorausgesetzt dass die Flip-Flops alle mit dem Wert Null initialisiert werden - lediglich ein einziges Bit durch das Schieberegister durchgeschoben werden muss. Durch Abzählen der dazu erforderlichen Taktflanken ergibt sich unmittelbar die Anzahl der Flip-Flops. Ist eine derartige Initialisierung nicht möglich, so kann jedoch auch ein anderes Testmuster für die Funktionsprüfung verwendet werden, wobei am Ausgang des Schieberegisters eine entsprechende Prüfung auf das Erscheinen des Testmusters vorgesehen werden muss.

Günstig ist es auch,
- wenn bei Nichtübereinstimmung des strukturellen Aufbaus des logischen Schaltkreises im Hardware-Emulator mit dem strukturellen Aufbau des Modells analysiert wird, welche Fehlerquellen dies begründen und
- wenn das Modell des logischen Schaltkreises automatisch ein weiteres mal, unter Ausschaltung dieser Fehlerquellen, in den Hardware-Emulator geladen wird.

Da eine Überprüfung, ob der Entwurf des logischen Schaltkreises auch die in ihn gesetzten Erwartungen erfüllt, in der Regel nur dann sinnvoll durchgeführt werden kann, wenn die Richtigkeit der Abbildung des Modells des logischen Schaltkreises auf den Hardware-Emulator gewährleist ist, wird das Modells automatisch ein weiteres mal in den Hardware-Emulator geladen, wenn diese Bedingung nicht zutrifft. Der Ablauf der Funktionsprüfung kann so besonders vorteilhaft gestaltet werden. Dabei werden die Fehler, welche zu dieser Nichtübereinstimmung geführt haben, analysiert und beim darauf folgenden Ladevorgang durch entsprechende Parametrierung des Ladevorgangs vermieden. Ein solcher Fehler kann beispielsweise durch ein defektes Modul des Hardware-Emulators hervorgerufen werden. Gegebenenfalls muss dieser Vorgang auch iterativ wiederholt werden, wenn beim Neuladen wiederum Fehler auftreten.

Die Aufgabe der Erfindung wird auch mit einer Vorrichtung zur Durchführung aller Schritte eines Verfahrens gelöst,
- welche einen Hardware-Emulator zur Emulierung eines als Modell vorliegenden logischen Schaltkreises, ein Testmuster-Generatormodul zum Anlegen eines Testmusters an einen Eingang des Hardware-Emulators, einen Taktgenerator zur Einspeisung eines Takts in den Hardware-Emulator und ein Testmuster-Prüfmodul zur Prüfung der Übereinstimmung eines an einem Ausgang des Hardware-Emulators anliegenden Bitmusters mit einem Erwartungswert umfasst und
- welche zusätzlich ein Modul zum Vergleich des strukturellen Aufbaus des logischen Schaltkreises im Hardware-Emulator mit dem strukturellen Aufbau des Modells des logischen Schaltkreises unter zumindest teilweiser Zuhilfenahme eines Betriebsmodus des logischen Schaltkreises, in dem einige oder alle der darin enthaltenen Flip-Flops, insbesondere unter Zwischenschaltung weiterer logischer Einheiten, funktional zu einem oder mehreren Schieberegistern verkettet sind, beinhaltet.

Die erfindungsgemäße Vorrichtung schafft die Voraussetzung, dass eine Funktionsprüfung des logischen Schaltkreises unter Zuhilfenahme eines Scan-Modus möglich ist und eine Aussage darüber getroffen werden kann, ob der strukturelle Aufbau des logischen Schaltkreises im Hardware-Emulator mit dem strukturellen Aufbau des logischen Schaltkreises im Modell des logischen Schaltkreises vergleichbar beziehungsweise überhaupt ident ist.

Besonders vorteilhaft ist es dabei, wenn die Vorrichtung ein Modul zur Ermittlung der Anzahl der im Schieberegister enthaltenen Flip-Flops aus der Anzahl der für das Durchschieben eines Testmusters erforderlichen Taktsequenzen und/oder ein Modul zum kurzfristigen Umschalten des logischen Schaltkreis in einen normalen Betriebsmodus für einen Taktzyklus oder mehrer Taktzyklen während des Durchschiebens eines Testmusters umfasst.

Mit Hilfe der Vorrichtung ist es beispielsweise möglich, die Anzahl der Flip-Flops des logischen Schaltkreises auf einfache Weise festzustellen und so eine Bedingung für die Gleichheit des Modells des logischen Schaltkreises und dessen Abbildung im Hardware-Emulator auszuwerten. Durch die Umschaltmöglichkeit in einen normalen Betriebsmodus werden die Testmöglichkeiten durch die Vorrichtung noch zusätzlich ausgeweitet.

Eine günstige Variante der Erfindung ist auch mit einer Vorrichtung gegeben, welche ein Modul zur Verkettung aller Schieberegister zu einem einzigen Schieberegister durch rekursive Verbindung des Ausganges je eines Schieberegisters mit dem Eingang je eines nächsten Schieberegisters umfasst.

Die Funktionsprüfung gestaltet sich hier, wie bereits beim erfindungsgemäßen Verfahren erwähnt, durch das Vorhandensein eines einzigen Schieberegisters besonders einfach. Die erfindungsgemäße Vorrichtung stellt diese Testmöglichkeit auch für logische Schaltkreise sicher, die über keine interne derartige Verkettungsmöglichkeit verfügen.

Günstig ist es auch,
- wenn diese ein Modul zur Analyse der Fehlerquellen, welche eine Nichtübereinstimmung des strukturellen Aufbaus des logischen Schaltkreises im Hardware-Emulator mit dem strukturellen Aufbau des Modells begründen, umfasst und
- wenn diese ein Modul zum automatischen Laden des Modells des logischen Schaltkreises in den Hardware-Emulator unter Ausschaltung dieser Fehlerquellen umfasst.

Diese Variante der Erfindung stellt eine vorteilhafte Vorrichtung zur komfortablen Funktionsprüfung eines Modells eines logischen Schaltkreises dar, da das Modell mit Hilfe des Moduls zum automatischen Laden ein weiteres mal in den Hardware-Emulator geladen wird, wenn die Richtigkeit der Abbildung des auf den Hardware-Emulator nicht gewährleist ist. Dabei werden die Fehler, welche zu dieser Nichtübereinstimmung geführt haben, mit Hilfe eines entsprechenden Moduls analysiert und beim darauf folgenden Ladevorgang durch entsprechende Parametrierung des Ladevorgangs vermieden. Ein solcher Fehler kann beispielsweise durch ein defektes Modul des Hardware-Emulators hervorgerufen werden.

Im Übrigen wird darauf hingewiesen, dass die beim erfindungsgemäßen Verfahren genannten Vorteile gleichermaßen für die entsprechende erfindungsgemäße Vorrichtung gelten und umgekehrt.

Die Erfindung wird nun anhand eines in den Figuren dargestellten Ausführungsbeispiels näher erläutert, welches die Funktionsprüfung eines in einem Hardware-Emulator abgebildeten logischen Schaltkreis betrifft.

Es zeigen:
- Figur 1:: eine Testanordnung zur Durchführung des erfindungsgemäßen Verfahrens mittels Verkettung der einzelnen Flip-Flops und temporärer Umschaltung des logischen Schaltkreises in einen normalen Betriebsmodus;
- Figur 2:: eine Testanordnung zur Durchführung des erfindungsgemäßen Verfahrens mittels Verkettung der einzelnen Flip-Flops zu einem einzigen Schieberegister;

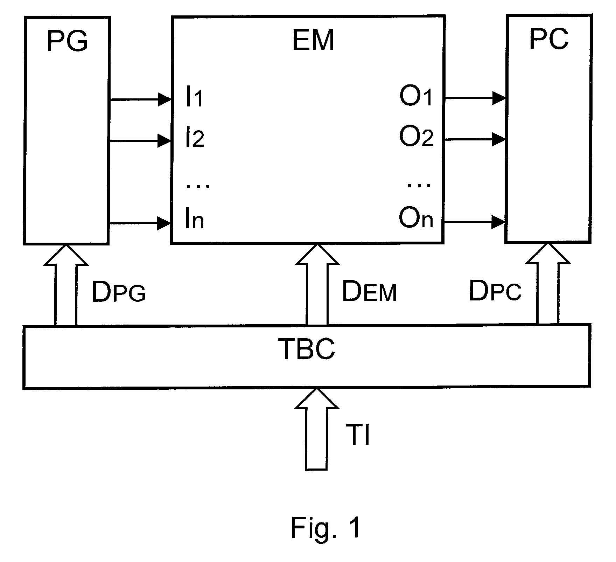

Die Figur 1 umfasst einen Hardware-Emulator EM, einen Testmustergenerator PG, ein Testmusterprüfmodul PC und ein Teststeuerungsmodul TBC. Der Testmustergenerator PG ist über n Verbindungen mit einem ersten bis n-ten Eingang I1..In des Hardware-Emulators EM zusammengeschaltet. Analog dazu ist das Testmusterprüfmodul PC über n Verbindungen mit einem ersten bis n-ten Ausgang O1..On des Hardware-Emulators EM zusammengeschaltet. Darüber hinaus umfasst die Vorrichtung ausgehend von der Teststeuerung TBC eine Datenverbindung zum Testmustergenerator DPG, eine Datenverbindung zum Testmusterprüfmodul DPC und eine Datenverbindung zum Hardware-Emulator DEM. Zuletzt existiert noch eine Datenverbindung zur Teststeuerung TI.

Die Funktion der in der Figur 1 dargestellten Vorrichtung ist wie folgt:

Über die Datenverbindung zur Teststeuerung TI werden die für den Test erforderlichen Informationen übermittelt, etwa die dem Test zugrunde zu legenden Testmuster. In Folge wird der im Hardware-Emulator abgebildete logische Schaltkreis in einen Betriebsmodus versetzt, in dem vorzugsweise alle der darin enthaltenen Flip-Flops, beziehungsweise auch andere logische Elemente wie etwa Inverter, funktional zu mehreren Schieberegistern verkettet werden

Danach erhält der Testmustergenerator PG von der Teststeuerung TBC die Anweisung ein bestimmtes Testmuster an den ersten bis n-ten Eingang 11..In des Hardware-Emulators EM anzulegen. Desgleichen werden dem Testprüfmodul PC die am ersten bis n-ten Ausgang O1..On des Hardware-Emulators EM erwarteten Ergebnismuster von der Teststeuerung TBC übermittelt.

Schließlich wird der eigentliche Test gestartet, indem von der Teststeuerung TBC ein Takt an den Hardware-Emulator EM angelegt wird. Sukzessive werden so bestimmte, variierende Testmuster, welche vom Testmustergenerator PG an den ersten bis n-ten Eingang I1..In des Hardware-Emulators EM angelegt werden, durch die zu einem Schieberegister verbundenen Flip-Flops durch den emulierten, logischen Schaltkreis durchgeschalten, vorzugsweise so lange, bis alle Schieberegister mit einem definierten Wert initialisiert sind.

Danach wird der logische Schaltkreis in einen normalen Betriebsmodus versetzt, in welchem die einzelnen Flip-Flops und anderen Bauteile logisch, entsprechend des Einsatzzweckes des logischen Schaltkreises, miteinander verbunden sind. Die Flip-Flops sind also nicht zwingend als Schieberegister organisiert. In Folge wird eine Taktflanke an den Schaltkreis angelegt, möglich sind aber auch mehrere. Aufgrund der Arbeitsweise des logischen Schaltkreises in diesem Zustand wird das Testmuster nun aber nicht bloß weitergeschoben, sondern es entsteht eine völlig neue Belegung der Flip-Flops abhängig von deren logischer Verknüpfung untereinander. Dieses Ergebnismuster, welches etwa auch aus der Simulation des Modells des logischen Schaltkreises bekannt ist, wird nun durch abermaliges Umschalten des logischen Schaltkreises in den Scan-Modus und entsprechendes Takten an den ersten bis n-ten Ausgang O1..On geschoben.

Mit Hilfe des Testmusterprüfmoduls PC kann nun festgestellt werden, ob der am ersten bis n-ten Ausgang 01..On anliegende Ergebniswert dem erwarteten Ergebniswert entspricht.

Sind die erwarteten Ergebnismuster mit den tatsächlich an den Ausgängen Ox anliegenden Ergebnismustern identisch, so kann davon ausgegangen werden, dass einerseits der Hardware-Emulator EM korrekt arbeitet, andererseits auch, dass das Modell des zu prüfenden logischen Schaltkreises auch fehlerfrei auf die Netzliste des Hardware-Emulators EM abgebildet wurde.

Ergänzend wird erwähnt, dass bei der Funktionsprüfung die Verkettung der Schieberegister mit Invertern und unterschiedlichen Längen der einzelnen Schieberegister zu berücksichtigen sind. Ersteres führt abhängig von der Anzahl der enthaltenen Inverter zu eventuell invertierten Bit-Mustern, zweiteres dazu, dass ein zu einem bestimmten Zeitpunkt an die Eingänge Ix angelegtes Bit-Muster zu unterschiedlichen Zeitpunkten an den Ausgängen Ox sichtbar wird.

Die für den Funktionstest notwendigen Bit-Muster können auch für den Hardware-Test des als Resultat vorliegenden Silizium-Chips, welcher den logischen Schaltkreis enthält, weiterverwendet werden, weswegen die Produktionskette vom Entwurf weg bis zur eigentlichen Fertigung und dem abschließenden Test besonders aufwandsarm ist.

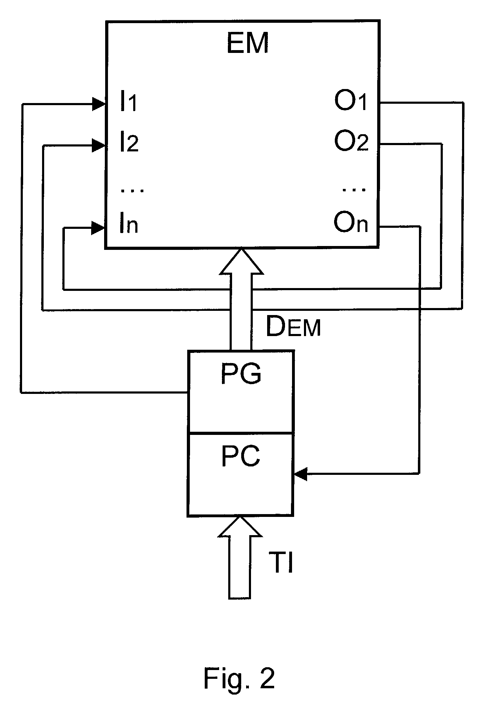

Figur 2 zeigt eine vereinfachte Vorrichtung zur Durchführung des erfindungsgemäßen Verfahrens. Diese umfasst wieder einen Hardware-Emulator EM, einen Testmustergenerator PG, und ein Testmusterprüfmodul PC. Anders als in Figur 1 ist jedoch der erste Ausgang O1 des Hardware-Emulators EM mit dem zweiten Eingang 12, der zweite Ausgang 02 mit dem dritten Eingang 13 verbunden usw., sodass lediglich der n-te Ausgang On nicht mit einem Eingang Ix des Hardware-Emulators EM verbunden ist.

Der Testmustergenerator PG ist schließlich mit dem ersten Eingang I1, der n-te Ausgang On mit dem Testmusterprüfmodul PC verbunden. Darüber hinaus umfasst die Vorrichtung eine Datenverbindung zum Hardware-Emulator DEM und eine Datenverbindung zum Testmusterprüfmodul TI.

Die Funktion der in der Figur 2 dargestellten Vorrichtung ist wie folgt:

Da die einzelnen Schieberegister durch die gezeigte Beschaltung zu einem einzigen Schieberegister verkettet sind, gestaltet sich das Durchschalten eines Testmusters einfacher, welches nun Bit für Bit durch das Schieberegister geschoben werden kann. Am n-ten Ausgang On muss lediglich die Anzahl der im Schieberegister eventuell enthaltenen Inverter berücksichtigt werden. Bei einer ungeraden Anzahl erscheint das Testmuster invertiert am n-ten Ausgang On. Eine Berücksichtigung unterschiedlicher Registerlängen, so wie das bei der in Figur 1 gezeigten Anordnung benötigt wird, ist nicht erforderlich.

Ist das in den ersten Eingang 11 eingespeiste Testmuster nun am n-ten Ausgang On feststellbar, so kann durch Auswertung der für das Durchreichen des Testmusters erforderlichen Taktzyklen auf die Anzahl der im Schieberegister enthaltenen Flip-Flops geschlossen werden. Stimmt die festgestellte Anzahl nicht mit der aus dem Modell des logischen Schaltkreises bekannten Anzahl überein, kann von einem Auftreten eines Fehlers ausgegangen werden.

Ein einfaches Testmuster ist beispielsweise ein einzelnes Bit, welches durch das Schieberegister durchgeschoben wird, wobei dafür zu sorgen ist, dass die einzelnen Flip-Flops mit dem Wert Null initialisiert sind.

## Patentansprüche

1. Verfahren zur Funktionsprüfung eines emulierten logischen Schaltkreises, bei dem ein Modell des logischen Schaltkreises in einer Hardware-Beschreibungssprache in einen Hardware-Emulator (EM) geladen wird,
**dadurch gekennzeichnet,**
- **dass** der emulierte logische Schaltkreis in einen Betriebsmodus versetzt wird, in dem einige oder alle der darin enthaltenen Flip-Flops, insbesondere unter Zwischenschaltung weitere logischer Einheiten, funktional zu einem oder mehreren Schieberegistern verkettet werden und
- **dass** der strukturelle Aufbau des logischen Schaltkreises im Hardware-Emulator (EM) unter zumindest teilweiser Zuhilfenahme dieses Betriebsmodus mit dem strukturellen Aufbau des Modells des logischen Schaltkreises verglichen wird.

2. Verfahren nach Anspruch 1,
**dadurch gekennzeichnet,**
- **dass** an Eingänge (Ix) des Emulators (EM), welche gleichzeitig Eingänge von Schieberegistern darstellen, ein Testmuster angelegt wird und durch entsprechendes Takten in die Schieberegister geschoben wird,
- **dass** der emulierte logische Schaltkreis in einen normalen Betriebsmodus versetzt wird, eine oder mehrere Taktzyklen folgen und der Schaltkreis anschließend wieder in den ursprünglichen Betriebsmodus versetzt wird,
- **dass** das daraus resultierende Ergebnismuster durch entsprechendes Takten an Ausgänge (Ox) des Emulators (EM), welche gleichzeitig Ausgänge der Schieberegister darstellen, geschoben wird und dort überprüft wird ob es mit einem Erwartungswert übereinstimmt und
- **dass** dieses Ergebnis für den Vergleich des strukturellen Aufbaus des logischen Schaltkreises im Hardware-Emulator (EM) mit dem strukturellen Aufbau des Modells des logischen Schaltkreises herangezogen wird.

3. Verfahren nach Anspruch 1,
**dadurch gekennzeichnet,**
- **dass** an einen Eingang (Ix) des Emulators (EM), welcher gleichzeitig den Eingang eines Schieberegisters darstellt, ein Testmuster angelegt wird,
- **dass** das Testmuster durch entsprechendes Takten durch das Schieberegister durchgeschoben wird,
- **dass** ein Ausgang (Ox) des Emulators (EM), welcher gleichzeitig den Ausgang dieses Schieberegisters darstellt, auf das Erscheinen dieses oder des invertierten Testmusters hin überprüft wird,
- **dass** aus der Anzahl der für das Durchschieben erforderlichen Taktsequenzen die Anzahl der im Schieberegister enthaltenen Flip-Flops ermittelt wird und
- **dass** dieses Ergebnis für den Vergleich des strukturellen Aufbaus des logischen Schaltkreises im Hardware-Emulator (EM) mit dem strukturellen Aufbau des Modells des logischen Schaltkreises herangezogen wird.

4. Verfahren nach Anspruch 3, **dadurch gekennzeichnet, dass** der Ausgang eines Schieberegisters (Ox) mit dem Eingang eines nächsten Schieberegisters (Ix+1) verbunden wird und durch Rekursion alle Schieberegister zu einem einzigen Schieberegister verkettet werden.

5. Verfahren nach einem der Ansprüche 1 bis 4, **dadurch gekennzeichnet,**
- **dass** bei Nichtübereinstimmung des strukturellen Aufbaus des logischen Schaltkreises im Hardware-Emulator (EM) mit dem strukturellen Aufbau des Modells analysiert wird, welche Fehlerquellen dies begründen und
- **dass** das Modell des logischen Schaltkreises automatisch ein weiteres mal, unter Ausschaltung dieser Fehlerquellen, in den Hardware-Emulator (EM) geladen wird.

6. Vorrichtung zur Durchführung aller Schritte eines Verfahrens nach einem der Ansprüche 1 bis 5,
welche einen Hardware-Emulator (EM) zur Emulierung eines als Modell vorliegenden logischen Schaltkreises, ein Testmuster-Generatormodul (PG) zum Anlegen eines Testmusters an einen Eingang (Ix) des Hardware-Emulators (EM), einen Taktgenerator zur Einspeisung eines Takts in den Hardware-Emulator (EM) und ein Testmuster-Prüfmodul (PC) zur Prüfung der Übereinstimmung eines an einem Ausgang (Ox) des Hardware-Emulators (EM) anliegenden Bitmusters mit einem Erwartungswert umfasst,
**dadurch gekennzeichnet,**
**dass** die Vorrichtung zusätzlich ein Modul zum Vergleich des strukturellen Aufbaus des logischen Schaltkreises im Hardware-Emulator (EM) mit dem strukturellen Aufbau des Modells des logischen Schaltkreises unter zumindest teilweiser Zuhilfenahme eines Betriebsmodus des logischen Schaltkreises, in dem einige oder alle der darin enthaltenen Flip-Flops, insbesondere unter Zwischenschaltung weiterer logischer Einheiten, funktional zu einem oder mehreren Schieberegistern verkettet sind, beinhaltet.

7. Vorrichtung nach Anspruch 6, **dadurch gekennzeichnet, dass** diese ein Modul zur Ermittlung der Anzahl der im Schieberegister enthaltenen Flip-Flops aus der Anzahl der für das Durchschieben eines Testmusters erforderlichen Taktsequenzen und/oder ein Modul zum kurzfristigen Umschalten des logischen Schaltkreis in einen normalen Betriebsmodus für einen Taktzyklus oder mehrer Taktzyklen während des Durchschiebens eines Testmusters umfasst.

8. Vorrichtung nach Anspruch 6 bis 7, **dadurch gekennzeichnet, dass** diese ein Modul zur Verkettung aller Schieberegister zu einem einzigen Schieberegister durch rekursive Verbindung des Ausganges (Ox) je eines Schieberegisters mit dem Eingang (Ix+1) je eines nächsten Schieberegisters umfasst.

9. Vorrichtung nach einem der Ansprüche 6 bis 8, **dadurch gekennzeichnet,**
- **dass** diese ein Modul zur Analyse der Fehlerquellen, welche eine Nichtübereinstimmung des strukturellen Aufbaus des logischen Schaltkreises im Hardware-Emulator (EM) mit dem strukturellen Aufbau des Modells begründen, umfasst und
- **dass** diese ein Modul zum automatischen Laden des Modells des logischen Schaltkreises in den Hardware-Emulator (EM) unter Ausschaltung dieser Fehlerquellen umfasst.
